# EUROPEAN PATENT APPLICATION

(11) **EP 4 125 135 A1**
(43) Date of publication of application: **01.02.2023**
(21) Application number: 21188175.0
(22) Date of filing: 28.07.2021
(51) Int. Cl.: H01L 29/78, H01L 29/66, H01L 29/20, H01L 29/08, H01L 29/10

(54) **A TRANSISTOR, AN ELECTRICAL DEVICE, AND A METHOD FOR PRODUCING A TRANSISTOR**

(71) Applicant: Epinovatech AB, 223 63 Lund (SE)
(72) Inventor: Olsson, Martin, 223 63 Lund (SE)
(74) Representative: AWA Sweden AB

(57) **Abstract**

A transistor (1) comprising a source (10), a body (12) and a drain (14), the transistor (1) further comprising
a plurality of semiconductor layers (20), wherein layers of the plurality of semiconductor layers (20) are made of AIGaN or GaN, and wherein the plurality of semiconductor layers (20) is configured such that an aluminum content changes between each consecutive layer such that every second layer has a lower aluminum content than the neighboring mutually opposite layers thereof, wherein the transistor (1) is either
a N-channel metal-oxide-semiconductor, NMOS, transistor (1'), wherein part of the plurality of semiconductor layers (20) is p-doped and forms part of the body (12) of the NMOS transistor (1'); or
a P-channel metal-oxide-semiconductor, PMOS, transistor (1"), wherein part of the plurality of semiconductor layers (20) is p-doped and forms part of the source (10) or the drain (14) of the PMOS transistor (1").

## Description

### TECHNICAL FIELD

The present inventive concept relates, in general, to a transistor, an electrical device, and a method for producing a transistor.

### BACKGROUND

GaN transistors are often used for electrical devices operating at high power and/or high frequency. Due to the large bandgap of GaN, such transistors may function at higher temperatures than e.g. Si transistors. However, there is still room for further improvements.

### SUMMARY

It is an objective of the present inventive concept to enable new types of GaN based transistors. It is a further objective of the present inventive concept to enable power efficient electrical devices. It is a further objective of the present inventive concept to enable power efficient electrical devices operating at high power and/or high frequency. These and other objectives of the inventive concept are at least partly met by the invention as defined in the independent claims. Preferred embodiments are set out in the dependent claims.

In this text abbreviations of the natural elements will be used in accordance with the periodic table. For example, Al means aluminum, Ga means gallium, As means arsenic, Mg means magnesium, O means oxygen, Si means silicon.

According to a first aspect, there is provided a transistor comprising a source, a body and a drain, the transistor further comprising a plurality of semiconductor layers, wherein layers of the plurality of semiconductor layers are made of AIGaN or GaN, and wherein the plurality of semiconductor layers is configured such that an aluminum content changes between each consecutive layer such that every second layer has a lower aluminum content than the neighboring mutually opposite layers thereof, wherein the transistor is either
a N-channel metal-oxide-semiconductor, NMOS, transistor, wherein part of the plurality of semiconductor layers is p-doped and forms part of the body of the NMOS transistor; or
a P-channel metal-oxide-semiconductor, PMOS, transistor, wherein part of the plurality of semiconductor layers is p-doped and forms part of the source or the drain of the PMOS transistor.

A NMOS transistor may comprise source/body/drain that are doped n/p/n, e.g. n+/p/n+. Thus, the source may be n-doped (e.g. strongly n-doped, indicated by n+), the body may be p-doped, and the drain may be n-doped (e.g. strongly n-doped, indicated by n+). A NMOS transistor may further comprise a gate contact and an electrical insulator between the gate contact and the body. An applied bias on the gate contact may create an electric field in the body, under the electrical insulator. The applied bias may thereby control the conduction of electrons between the source and the drain, via the body.

A PMOS transistor may comprise source/body/drain that are doped p/n/p, e.g. p+/n/p+. Thus, the source may be p-doped (e.g. strongly p-doped, indicated by p+), the body may be n-doped, and the drain may be p-doped (e.g. strongly p-doped, indicated by p+). A PMOS transistor may further comprise a gate contact and an electrical insulator between the gate contact and the body. An applied bias on the gate contact may create an electric field in the body, under the electrical insulator. The applied bias may thereby control the conduction of holes between the source and the drain, via the body.

P-doping may be hard to achieve in GaN based materials. Doping atoms, such as Mg, used for p-doping are often passivated by hydrogen impurities or nitrogen vacancies. Therefore, the free hole concentration may be low even if the doping concentration is high. To remove the passivation (or activate the doping atoms), post-growth annealing may be used, e.g. post-growth annealing in an atmosphere of low hydrogen concentration.

It is a realization that the plurality of semiconductor layers may remove or reduce the need for post-growth annealing of p-doped GaN based materials. This enables new types of transistors such as the NMOS and PMOS transistors according to the first aspect. A transistor comprising both n-doped and p-doped regions (such as n/p/n or p/n/p-doped source/body/drain) may degrade during post-growth annealing. For example, diffusion of material due to post-growth annealing may change doping profiles (n dopants may e.g. diffuse into nominally p-doped regions or vice versa) and/or material profiles (Al may e.g. diffuse from Al rich regions into Ga rich regions or Ga may diffuse from Ga rich regions into Al rich regions).

The plurality of semiconductor layers may enhance the p-doping through a variation in the valence-band edge, as described by Kozodoy et al. [Appl. Phys. Lett. 75, 2444 (1999)]. The variation in the valence-band edge is herein caused by the variation in Al content in the plurality of semiconductor layers. Acceptors may be ionized where the band edge is far below the Fermi energy and the resulting holes may accumulate where the band edge is close to the Fermi level. The valence-band edge may herein vary in a direction perpendicular to the layers of the plurality of semiconductor layers. As a consequence of the variation in the valence-band edge, the hole concentration may also vary. However, the average hole concentration may be higher than in a bulk film wherein the valence-band edge does not vary. It should be understood that the variation in the valence-band edge may be due to a varying bandgap in the plurality of semiconductor layers as well as polarization effects due to band bending.

The plurality of semiconductor layers may also enhance the hole mobility, as further described by Kozodoy et al. [Appl. Phys. Lett. 75, 2444-2446 (1999)].

A transistor according to the first aspect may have one or more advantages over conventional transistors. As the need for post-growth annealing may be removed or reduced, the transistor may be based on combinations of n-doped and p-doped regions. This gives a large flexibility in the transistor design. Further, as the need for post-growth annealing may be removed or reduced, the size of the transistor may be smaller without diffusion degrading the performance of the transistor. The smaller the features becomes, e.g. the smaller the doped regions becomes, the more severe the effects of diffusion may be.

Further, a high hole concentration in the p-doped regions, due to the plurality of semiconductor layers, may have several advantages for the transistor. In the case of the NMOS transistor, wherein part of the plurality of semiconductor layers is p-doped and forms part of the body of the transistor, a high hole concentration in the body of the transistor may have advantageous effects. As described by Ziabari et al. [Chinese Journal of Physics, 51(4), 844-853] a high hole concentration in the body of the transistor may e.g. improve short channel effects. In the case of the PMOS transistor, wherein part of the plurality of semiconductor layers is p-doped and forms part of the source or the drain of the transistor, a high hole concentration in the source and/or drain of the transistor may have advantageous effects. A high hole concentration may facilitate making ohmic contacts to said source and/or drain.

Further, a high hole mobility may facilitate fast switching and/or high operating frequencies of the transistor. The switching speed and/or high operating frequencies may be further improved by ballistic transport. With ballistic transport, mobilities can be improved by 9 orders of magnitude compared to a bulk GaN film at room temperature. Ballistic transport may be achieved by superlattices of AlGaN/GaN heterostructures at specific alloy compositions of AIGaN.

It is a further realization that a NMOS or PMOS transistor according to the first aspect facilitates complementary metal-oxide-semiconductor (CMOS) technology which may provide power efficient electrical devices. In a CMOS device, PMOS and NMOS transistors may be connected pairwise such that when one type of transistor (e.g. NMOS) is turned on, the other type of transistor (e.g. PMOS) is turned off, and vice versa. Thus, power may mainly be consumed during switching and not during static operation. A CMOS device may be manufactured from NMOS transistors according to the first aspect and PMOS transistors according to the first aspect. Alternatively, a CMOS device may be manufactured from NMOS transistors according to the first aspect and any type of PMOS transistors. Alternatively, a CMOS device may be manufactured from any type of NMOS transistors and PMOS transistors according to the first aspect.

It should be understood that the source, body, and drain of the transistor may be part of the same semiconductor structure. However, the semiconductor structure may comprise other parts than the plurality of semiconductor layers.

The plurality of semiconductor layers may comprise a repetition of a pair of semiconductor layers, wherein each pair of semiconductor layers comprises
a low Al content layer, having an Al content below 10%; and
a high Al content layer, having an Al content above 15%.

Thus, the low Al content layer may be a layer of AlₓGa₁₋ₓN, wherein x<0.1. Similarly, the high Al content layer may be a layer of AlₓGa₁₋ₓN, wherein x>0.15. It is preferred that all low Al content layers have the same composition and that they have an Al content of zero, i.e. they comprise GaN, i.e. x=0. It is preferred that all high Al content layers have the same composition and that they have an Al content between 20% and 40%, i.e. they comprise a material ranging from Al_{0.2}Ga_{0.8}N to Al_{0.4}Ga_{0.6}N, i.e. 0.2<x<0.4. An example of a plurality of semiconductor layers comprising four layers may be Al_{0.2}Ga_{0.8}N/GaN/Al_{0.2}Ga_{0.8}N/GaN or Al_{0.3}Ga_{0.7}N/GaN/ Al_{0.3}Ga_{0.7}N/GaN.

As an alternative, each pair of semiconductor layers may comprise a low and high Al content layer but all low Al content layers may not necessarily have the same Al content. Similarly, all high Al content layers may not necessarily have the same Al content. Thus, the plurality of semiconductor layers may be e.g. Al_{0.2}Ga_{0.8}N/ Al_{0.05}Ga_{0.95}N/ Al_{0.16}Ga_{0.84}N/ GaN or Al_{0.3}Ga_{0.7}N/ Al_{0.09}Ga_{0.91}N/ Al_{0.22}Ga_{0.78}N/ Al_{0.02}Ga_{0.98}N/ Al_{0.2}Ga_{0.8}N/ Al_{0.07}Ga_{0.93}N.

Layers with a low Al content may, as a first approximation, have a smaller bandgap than layers with a high Al content. This may give rise to a variation in the valence band edge. However, polarization effects and/or strain effects between the low and high Al content layers, may modify the variation in the valence band edge. For example, local energy minima and local energy maxima in the varying valence band edge may lie at interfaces between high Al content layers and low Al content layers. To exemplify, assuming that the surface of the crystal is Ga face (this may be the case when MOCVD is used to initiate growth on sapphire) going from the substrate and upwards through the plurality of semiconductor layers local energy minima may appear at interfaces in the conduction band where a low Al content layer transitions into a high Al content layer (let us label this region A) and local energy maxima may appear at interfaces where a high Al content layer transitions into a low Al content layer (let us label this region B). The above description is in analogy with the description on page 2445 of [Appl. Phys. Lett. 75, 2444-2446 (1999)] which is hereby included by reference.

It should be noted that when this text refers to the plurality of semiconductor layers being p-doped it can be construed as the plurality of semiconductor layers being p-doped in A regions but not in B regions. Such doping may give rise to the highest hole mobilities. However, it may of course also be construed as the plurality of semiconductor layers being p-doped throughout the layers of the plurality of semiconductor layers.

The transistor may be configured such that each layer, of the plurality of semiconductor layers, has a thickness between 3 nm and 10 nm. The layers may all have the same thickness, e.g. all layers having a thickness of 3 nm, all layers having a thickness of 6 nm, or all layers having a thickness of 10 nm. Alternatively, the plurality of semiconductor layers may comprise layers of different thicknesses. For example, all low Al content layers may have a thickness between 3 nm and 10 nm and all high Al content layers may have a thickness between 3 nm and 10 nm, wherein the thickness of the low Al content layers is different from the thickness of the high Al content layers. For example, each pair of semiconductor layers may comprise e.g. a 6 nm thick low Al content layer and a 5 nm thick high Al content layer.

In the 3-10 nm thickness range the enhancement of the p-doping may be most efficient. For example, the polarization effects and/or strain effects between the low and high Al content layers may be most effective in said thickness range.

The transistor may be configured to pass a current mainly in a direction parallel to the layers of the plurality of semiconductor layers. Thus, the current may flow without being hindered by any variation in the band edges. Such a transistor may be called a lateral transistor. A lateral transistor may be compatible with conventional processing technology, e.g. conventional CMOS technology, and therefore be produced in a cost-effective manner. A lateral transistor may comprise a source contact connected to the source, a gate contact connected to the body, and a drain contact connected to the drain. The source contact, gate contact, and drain contact may be arranged side by side, e.g. in the same plane, on the semiconductor structure comprising the transistor.

Alternatively, the transistor may be configured to pass a current mainly in a direction orthogonal to the layers of the plurality of semiconductor layers. Thus, the current may flow in the vertical direction, i.e. in the epitaxial growth direction, of the semiconductor structure comprising the transistor. For example, the current may flow vertically through an integrated circuit (IC) chip comprising the transistor. Such a transistor may be called a vertical transistor. A vertical transistor may have a small footprint as it may be easy to arrange the source contact, gate contact, and drain contact in a manner that is not side by side. For example, one contact may be at a top side of the semiconductor structure while another contact may be at a back side of the semiconductor structure. It should be understood that, although vertical transistors may be manufactured differently than lateral transistors, the manufacturing methodology may still, to a large extent, be based on conventional CMOS technology.

Further, the transistor may be configured such that a nanowire confines at least part of the body of the transistor. For example, a semiconductor structure, comprising the source, body, and drain, may be epitaxially grown. One or more nanowires may then be etched out from the top, through at least part of the body. Thereby, the body of the transistor may be confined in a nanowire. Accordingly, the nanowire may preferably be a top-down manufactured nanowire. However, it should be understood that the nanowire may alternatively be a bottom-up manufactured nanowire, e.g. manufactured though selective area growth or nanoparticle assisted growth. Doping profiles, material interfaces, surface states etc. may be more controllable in top-down nanowires than in bottom-up nanowires. The nanowire may have a diameter smaller than 100 nm, such as e.g. between 5 nm and 100 nm or between 10 nm and 50 nm. The axial length of the nanowires may be 200-1000 nm. Ballistic transport of 200 nm has been demonstrated in gallium nitride at room temperature. Such diameters may give rise to quantum confinement effects in the body of the transistor.

Having the body of the transistor confined in a nanowire may be advantageous. For example, charge carriers may have an increased mobility due to quantum confinement effects. The transistor may thereby have a short switching time and/or be operated at a high frequency. Further, the transistor may have a small footprint when the body of the transistor is confined in a nanowire. Thus, many transistors may be fitted in a small area.

It should be understood that an alternative to confining the body of the transistor in a nanowire may be to confine the body of the transistor in a micropillar. The micropillar may have a diameter smaller than 1 µm, such as e.g. between 5 nm and 500 nm. Even if confinement effects may be small, other advantages may still be present, such as the transistor having a small footprint.

The transistor may be configured such that a gate contact wraps around the nanowire that confines at least part of the body of the transistor, whereby the gate contact forms a wrap-around gate. The wrap-around gate may surround the body along a circumference of the nanowire. Thus, the wrap-around gate may efficiently control charge carriers in the body. The wrap-around gate may ensure a low leakage current and/or overcome other short channel effects.

The nanowire that confines at least part of the body of the transistor may also confine at least part of the source and the drain of the transistor. Again, confinement effects may provide advantages, such as giving rise to a high mobility and ballistic transport. Further, having the source and the drain of the transistor confined in the nanowire may facilitate a single nanowire transistor which may result in a small footprint of the transistor.

The source, drain, and body of the transistor may all comprise the plurality of semiconductor layers. Thus, also n-doped regions of the transistor may comprise the plurality of semiconductor layers. It is possible that the plurality of semiconductor layers may give rise to a high mobility for electrons as well as for holes. Further, when manufacturing a CMOS circuit, wherein the NMOS transistors comprise a plurality of semiconductor layers in the body and the PMOS transistors comprise a plurality of semiconductor layers in the source and drain, it may be advantageous that the material structure is the same for both the NMOS and the PMOS transistors. Thus, one single semiconductor structure may be epitaxially grown, e.g. comprising the plurality of semiconductor layers, and to create a NMOS or PMOS transistor may simply be a question of which doping sequence is chosen (e.g. n/p/n or p/n/p). The doping may herein be done after the epitaxial growth. Consequently, an efficient manufacturing process may be achieved.

The transistor may be a NMOS transistor, wherein
a source of the NMOS transistor comprises a n-doped GaN layer; and
a drain of the NMOS transistor comprises a n-doped GaN layer.

Such a transistor may have various advantages. For example, it may be easy to make high quality ohmic contacts to n-doped GaN.

According to a second aspect, there is provided an electrical device comprising:
at least one N-channel metal-oxide-semiconductor, NMOS, transistor, the at least one NMOS transistor comprising a plurality of semiconductor layers, wherein each layer of the plurality of semiconductor layers of the NMOS transistor is made of AIGaN or GaN, and wherein the plurality of semiconductor layers of the NMOS transistor is configured such that an aluminum content changes between each consecutive layer such that every second layer has a lower aluminum content than the neighboring mutually opposite layers thereof, wherein the plurality of semiconductor layers of the NMOS transistor forms part of a p-doped body of the NMOS transistor; and
at least one a P-channel metal-oxide-semiconductor, PMOS, transistor, the at least one PMOS transistor comprising a plurality of semiconductor layers, wherein each layer of the plurality of semiconductor layers of the PMOS transistor is made of AIGaN or GaN, and wherein the plurality of semiconductor layers of the PMOS transistor is configured such that an aluminum content changes between each consecutive layer such that every second layer has a lower aluminum content than the neighboring mutually opposite layers thereof, wherein the plurality of semiconductor layers of the PMOS transistor forms part of a p-doped source or drain of the PMOS transistor,
wherein the at least one NMOS transistor and the at least one PMOS transistor of the electrical device are connected to form a complementary metal-oxide-semiconductor, CMOS, circuit.

Thus, a CMOS circuit may be provided wherein a plurality of semiconductor layers (although not necessarily the same plurality of semiconductor layers) is used both in the NMOS transistor and in the PMOS transistor to enhance the p-doping. The at least one NMOS transistor and the at least one PMOS transistor may be connected to form a CMOS circuit when said PMOS and NMOS transistors are connected pairwise such that when one type of transistor (e.g. NMOS) is turned on, the other type of transistor (e.g. PMOS) is turned off, and vice versa. Thus, power may mainly be consumed during switching and not during static operation. Consequently, an electrical device according to the second aspect may be a power efficient electrical device.

It should be understood that advantages may be achieved also for a CMOS circuit wherein the plurality of semiconductor layers is used either in the NMOS transistor or in the PMOS transistor to enhance the p-doping. Such a CMOS circuit may e.g. be more power efficient than a corresponding CMOS circuit wherein neither the NMOS transistor nor the PMOS transistor comprise the plurality of semiconductor layers.

The device may be configured such that the at least one NMOS transistor and the at least one PMOS transistor of the CMOS circuit share the same plurality of semiconductor layers.

Thus, one single semiconductor structure may be epitaxially grown, e.g. comprising the plurality of semiconductor layers, and both a NMOS and a PMOS transistor of a CMOS circuit may be manufactured out of the same plurality of semiconductor layers. Consequently, an efficient manufacturing process may be achieved. For example, the shared plurality of semiconductor layers may run through the source, body and drain of a NMOS transistor as well as a through the source, body and drain of a PMOS transistor, e.g. in a lateral transistor. Thus, source, body and drain of each transistor may share the plurality of semiconductor layers and the NMOS and PMOS transistors also share the plurality of semiconductor layers. Alternatively, the shared plurality of semiconductor layers may run through the body of a NMOS transistor and the source or drain of a PMOS transistor. Thus, the NMOS and PMOS transistors may share the plurality of semiconductor layers even though for each individual transistor the source, body and drain does not necessarily comprise the plurality of semiconductor layers.

A NMOS transistor and a PMOS transistor may share the same plurality of semiconductor layers if the shared plurality of semiconductor layers is originally epitaxially grown as one single plurality of semiconductor layers. Even if the transistors have been separated by removing, e.g. by etching, part of the plurality of semiconductor layers between them, the transistors may still be considered to share the same plurality of semiconductor layers.

It should be understood that at least one of the at least one PMOS transistor and/or at least one of the at least one NMOS transistor of the CMOS circuit of the electrical device may be a transistor according to the first aspect.

According to a third aspect, there is provided a method for producing a transistor, said method comprising;
epitaxially growing a first n-doped layer of AIGaN or GaN;
epitaxially growing a plurality of semiconductor layers, wherein the plurality of semiconductor layers is grown on top of the first n-doped layer, wherein each layer of the plurality of semiconductor layers is made of AIGaN or GaN, and wherein the plurality of semiconductor layers is configured such that an aluminum content changes between each consecutive layer such that every second layer has a lower aluminum content than the neighboring mutually opposite layers thereof, wherein the plurality of semiconductor layers is grown p-doped;
epitaxially growing a second n-doped layer of AIGaN or GaN, wherein the second n-doped layer is grown on top of the plurality of semiconductor layers; whereby the first n-doped layer, the plurality of semiconductor layers, and the second n-doped layer form part of a semiconductor structure, the method further comprising:
electrically connecting one of the first and second n-doped layers to a source contact and the other of the first and second n-doped layers to a drain contact, whereby a transistor source and a transistor drain are formed by the first and second n-doped layers;
arranging a gate contact on the semiconductor structure, the gate contact being configured to apply an electric field to the plurality of semiconductor layers, such that an electrical conduction between the source and the drain, via the plurality of semiconductor layers, is controllable by the gate contact, whereby a transistor body is formed by the plurality of semiconductor layers.

The method may thus produce a NMOS transistor.

The structure may be epitaxially grown by metal organic vapor phase epitaxy (MOVPE). However, other epitaxial growth methods may alternatively be used, e.g. molecular beam epitaxy (MBE). The structure may be epitaxially grown in one growth session or in several sessions. For example, part of the structure may be epitaxially grown in one session, then partially etched, then epitaxial growth may continue in a second session.

The method may further comprise etching out a nanowire from the plurality of semiconductor layers.

Thus, the plurality of semiconductor layers in the transistor body may be confined in a nanowire.

For example, a nanowire may be etched out from the second n-doped layer, the plurality of semiconductor layers, and the first n-doped layer, such that said nanowire extends from the second n-doped layer, via the plurality of semiconductor layers, and into the first n-doped layer.

Thus, the source and the drain of the transistor may, in addition to the body of the transistor, be confined in the nanowire.

An electrical device according to the second aspect may have the same advantages, or similar advantages, as the transistor according to the first aspect. Similarly, the method according to the third aspect may have the same advantages, or similar advantages, as the transistor according to the first aspect.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
- Fig. 1: illustrates a PMOS transistor
- Fig. 2: illustrates a NMOS transistor
- Fig. 3: illustrates an electrical device
- Fig. 4: illustrates a NMOS transistor
- Fig. 5: illustrates a NMOS transistor
- Fig. 6: illustrates a PMOS transistor
- Fig. 7: illustrates source and gate contacts
- Fig. 8: illustrates source, drain and gate contacts
- Fig. 9: illustrates a NMOS transistor
- Fig. 10: illustrates a PMOS transistor
- Fig. 11: illustrates an electrical device
- Fig. 12: illustrates a flow chart

### DETAILED DESCRIPTION

In cooperation with attached drawings, the technical contents and detailed description of the present invention are described thereinafter according to preferable embodiments, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

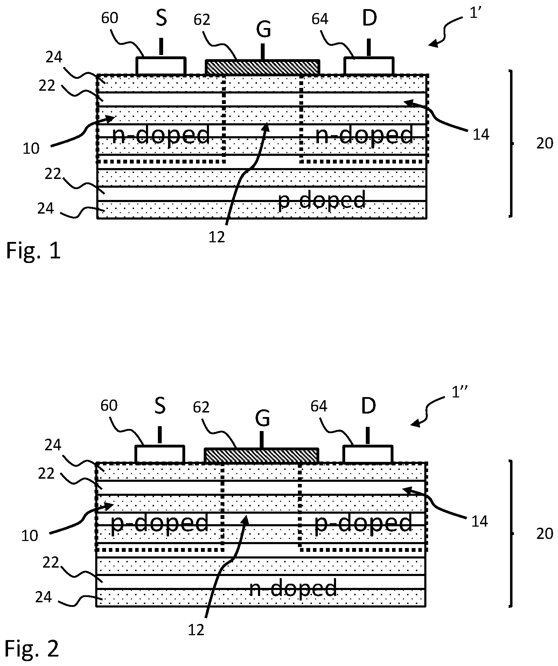

Figs. 1 and 2 illustrate cross sectional views of lateral transistors 1. Fig. 1 illustrates a NMOS transistor 1' and Fig. 2 illustrates a PMOS transistor 1". Each of the illustrated transistors 1 comprises a plurality of semiconductor layers 20. The plurality of semiconductor layers 20 comprise layers of AIGaN or GaN. The aluminum content changes between each consecutive layer such that every second layer has a lower aluminum content than the neighboring mutually opposite layers thereof. Every second layer, e.g. even numbered layers, may be low Al content layers 22 and layers in between, e.g. odd numbered layers, may be high Al content layers 24. The terms "high" and "low" should herein be construed in relative terms. The low Al content layers 22 may have an Al content below 10% and the high Al content layers 24 may have an Al content above 15%. For example, each low Al content layer 22 may be a GaN layer or an Al_{0.05}Ga_{0.95}N layer. Further, each high Al content layer 24 may be an Al_{0.2}Ga_{0.8}N, or an Al_{0.3}Ga_{0.7}N, or have any composition in-between. Thus, the plurality of semiconductor layers 20 may comprise a repetition of a pair of semiconductor layers, each pair of semiconductor layers comprising a low Al content layer 22 and a high Al content layer 24. The repetition may be a periodic repetition.

Each layer 22, 24 of the plurality of semiconductor layers 20 may have a thickness between 3 nm and 10 nm. For example, each layer may have a thickness of 6 nm or 8 nm.

The plurality of semiconductor layers 20 illustrated in Fig. 1 and 2 may be epitaxially grown, e.g. by MOVPE, on a substrate (not shown), e.g. a Si, SiC, or sapphire substrate. The plurality of semiconductor layers 20 may be doped, with n-type, or p-type dopants, during epitaxial growth. The plurality of semiconductor layers 20 may be further doped, e.g. in certain regions, after epitaxial growth. Certain regions may e.g. be doped through diffusion from a gas phase or through ion implantation, such regions are illustrated in Figs. 1 and 2 by dashed lines.

Fig. 1 illustrates a semiconductor structure comprising a plurality of semiconductor layers 20 which is p-doped during epitaxial growth. N-doped regions have then been created after epitaxial growth to form the source 10 and drain 14 of the NMOS transistor 1'. The n-doped regions are separated by a p-doped region which forms the body 12 of the NMOS transistor 1'. A source contact 60 electrically connects to the source 10 and a drain contact 64 electrically connects to the drain 14. A gate contact 62 is arranged on the semiconductor structure and configured to apply an electric field to the body 12 of the NMOS transistor 1' such that an electrical conduction between the source 10 and the drain 14, via the body 12, is controllable by the gate contact 62. In the illustration, the source contact 60, gate contact 62, and drain contact 64 are arranged side by side on the semiconductor structure comprising the NMOS transistor 1'. In the illustration, the gate contact 62 is arranged between the source contact 60 and the drain contact 64. The source contact 60 and drain contact 64 may comprise metal, e.g. metal partially diffused into the source 10 and drain 14 respectively. The gate contact 62 may comprise metal or another electrically conductive material, e.g. doped polysilicon. An electrical insulator, e.g. an oxide, may separate the semiconductor structure from the metal (or other electrically conductive material) of the gate contact 62.

Fig. 2 illustrates a semiconductor structure comprising a plurality of semiconductor layers 20 which is n-doped during epitaxial growth. P-doped regions have then been created after epitaxial growth to form the source 10 and drain 14 of the PMOS transistor 1". The p-doped regions are separated by a n-doped region which forms the body 12 of the NMOS transistor 1'. A source contact 60 electrically connects to the source 10 and a drain contact 64 electrically connects to the drain 14. A gate contact 62 is arranged on the semiconductor structure and configured to apply an electric field to the body 12 of the PMOS transistor 1" such that an electrical conduction between the source 10 and the drain 14, via the body 12, is controllable by the gate contact 62. In the illustration, the source contact 60, gate contact 62, and drain contact 64 are arranged side by side on the semiconductor structure comprising the PMOS transistor 1". In the illustration, the gate contact 62 is arranged between the source contact 60 and the drain contact 64. The source contact 60 and drain contact 64 may comprise metal, e.g. metal partially diffused into the source 10 and drain 14 respectively. The gate contact 62 may comprise metal or another electrically conductive material, e.g. doped polysilicon. An electrical insulator, e.g. an oxide, may separate the semiconductor structure from the metal (or other electrically conductive material) of the gate contact 62.

In Figs. 1 and 2 the source 10, drain 14, and body 12 of the transistor 1', 1" all comprise the plurality of semiconductor layers 20. Further, the illustrated transistors 1', 1" are configured to pass a current mainly in a direction parallel to the layers of the plurality of semiconductor layers 20. For example, a current may enter the source 10 from the source contact 60. Part of the current may then flow at least some distance orthogonal to the layers of the plurality of semiconductor layers 20 after which the current may flow mainly laterally. Thus, the current may flow mainly in a direction parallel to the layers of the plurality of semiconductor layers 20 through the body of the transistor 1', 1". In fact, the current may flow in a direction parallel to the layers of the plurality of semiconductor layers 20 through the body of the transistor 1', 1". The current may exit through the drain 14 and the drain contact 64. Part of the current may then flow at least some distance orthogonal to the layers of the plurality of semiconductor layers 20 in the drain 14 of the transistor 1', 1".

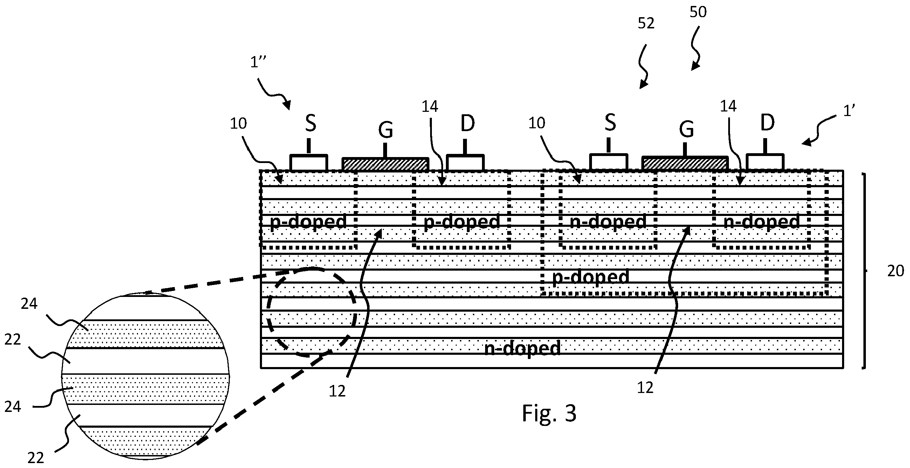

Fig. 3 illustrates a cross sectional view of an electrical device 50 comprising a CMOS circuit 52. The CMOS circuit 52 comprises an NMOS transistor 1' and a PMOS transistor 1". The NMOS transistor 1' comprises a plurality of semiconductor layers 20 and the PMOS transistor 1" comprises a plurality of semiconductor layers 20. In the illustration the NMOS transistor 1' and the PMOS transistor 1" of the CMOS circuit 52 share the same plurality of semiconductor layers 20. The NMOS transistor 1' and the PMOS transistor 1" are both lateral transistors. In the illustration, each layer of the shared plurality of semiconductor layers 20 run through both the NMOS transistor 1' and the PMOS transistor 1". Further, within each transistor 1', 1" of the CMOS circuit 52, the source 10, body 12, and drain 14 share the plurality of semiconductor layers 20.

The shared plurality of semiconductor layers 20 in the CMOS circuit 52 in Fig. 3 may be a plurality of semiconductor layers 20 that is epitaxially grown as n-doped. The PMOS transistor 1" may then be produced by p-doping a source 10 and drain 14, as described in conjunction with Fig. 2. The NMOS transistor 1' may be produced by firstly p-doping a region the NMOS transistor 1' to form the body of the NMOS transistor 1' and secondly, within said p-doped region, n-doping two regions to form the source 10 and drain 14 of the NMOS transistor 1', as illustrated in the figure.

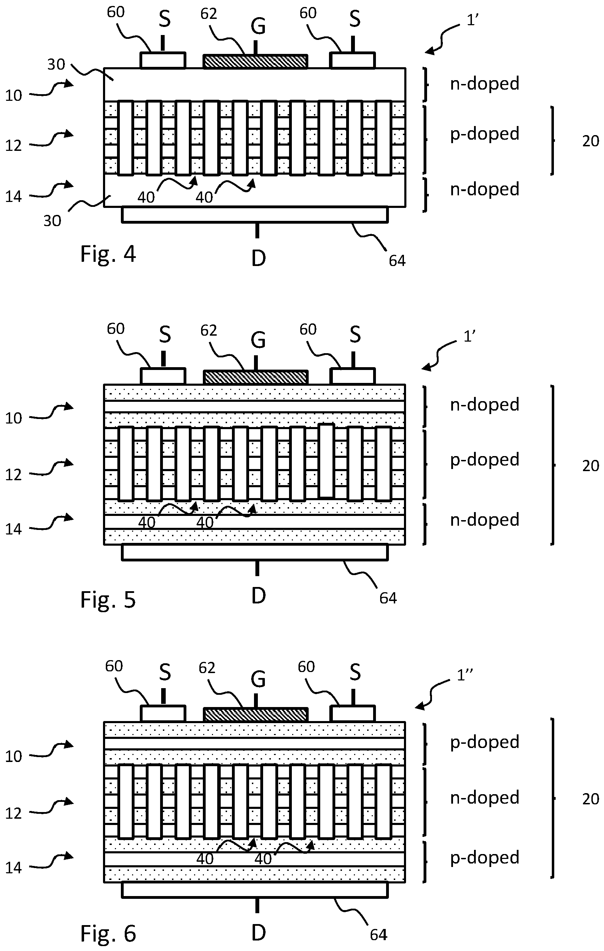

Figs. 4-6 illustrate cross sectional views of vertical transistors 1. Figs. 4 and 5 illustrate NMOS transistors 1' and Fig. 6 illustrates a PMOS transistor 1".

Fig. 4 illustrates a NMOS transistor 1', wherein the p-doped body 12 comprises the plurality of semiconductor layers 20, of varying Al content, and wherein the n-doped source 10 and drain 14 do not comprise the plurality of semiconductor layers 20. Instead the source 10 and drain 14 may comprise one single material, e.g. GaN. Thus, as illustrated a source 10 of the NMOS transistor 1' may comprise a n-doped GaN layer 30; and
a drain 14 of the NMOS transistor 1' may comprise a n-doped GaN layer 30.

Fig. 5 illustrates a NMOS transistor 1', wherein the p-doped body 12 comprises the plurality of semiconductor layers 20, of varying Al content, and wherein both the n-doped source 10 and drain 14 also comprise the same plurality of semiconductor layers 20.

Fig. 6 illustrates a PMOS transistor 1", wherein both the p-doped source 10 and drain 14 comprise the plurality of semiconductor layers 20, of varying Al content, and wherein the n-doped body also comprises the same plurality of semiconductor layers 20.

As illustrated in Figs. 4-6, a nanowire 40 may confine at least part of the body 12 of the transistor 1. The figures show a plurality of nanowires 40 within the body 12 of the transistor 1. The nanowires 40 may be configured such that at least a part of the current trough the body 12 may run through the nanowires 40. Thus, a nanowire 40 of the plurality of nanowires may confine at least part of the body 12 of the transistor 1. In each of Figs. 4-6 the body 12 of the transistor 1 may be seen as being confined by the plurality of nanowires 40. The nanowires 40 may be etched out, e.g. etched out after epitaxial growth of the body 12 but before epitaxial growth of the source 10 or drain 14. The nanowires 40 may have a diameter smaller than 100 nm. The intermediate space between nanowires 40 may be filled with electrically insulating material, e.g. an oxide or iron-doped gallium nitride GaN:Fe. Such filling of the intermediate space may be done after etching out the nanowires 40 and before further epitaxial growth. In the figures the nanowires 40 extend only within the body 12. Alternatively, the nanowires 40 may of course also extend into the source 10 and/or drain 14. As seen in the figures, the plurality of semiconductor layers 20 may be stacked in the axial direction of the nanowires 40.

The transistors 1 illustrated in Figs. 4-6 are all configured to pass a current mainly in a direction orthogonal to the layers of the plurality of semiconductor layers 20. In the figures, this is implemented by having source contacts 60 and drain contacts 64 on opposite sides of the plurality of semiconductor layers 20. The gate contact 62 may then be arranged on the same side as the source contacts 60 or the drain contacts 64 (in the figures on the same side as the source contacts 60). Nevertheless, the gate contact 62 may be arranged in the vicinity of both the body 12 and the (in this case) source contacts 60 such that an electrical conduction, such as an electrical current, between the source 10 and the drain 14, via the plurality of semiconductor layers 20, is controllable by the gate contact. In the figures, the proximity between the gate contact 62 and the source contacts 60 may be such that an electric field created by the gate contact 62 may open and close a current path between the source contacts 60 and the drain contacts 64.

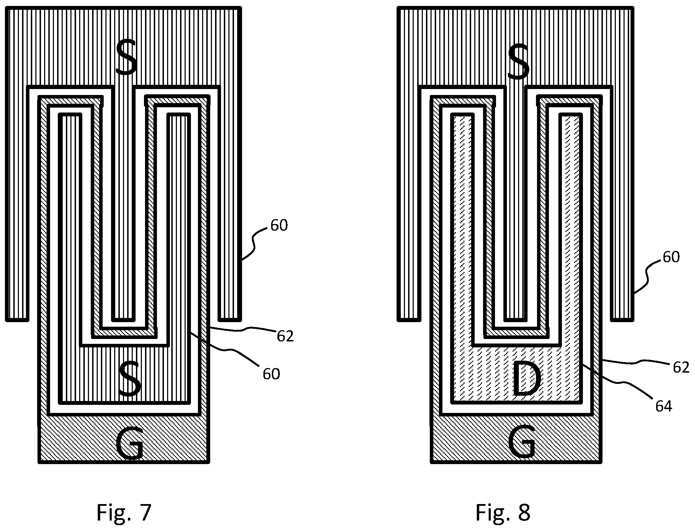

Fig. 7 illustrates a top view of a gate contact 62 and two source contacts 60. The contacts are interdigitated with fingers of each contact being intertwined with fingers of the other contacts. Fig. 7 may be seen as illustrating a top view of any one of the transistors 1 shown in Figs. 4-6. The two source contacts 60 shown in the cross sectional views of Figs. 4-6 may be seen as cross sections of two of the fingers of the interdigitated source contacts 60 shown in the top view of Fig. 7. Similarly, the gate contact 62 shown in the cross sectional views of Figs. 4-6 may be seen as cross section of a finger of the gate contact 62 shown in the top view of Fig. 7. As an addition or alternative to the contact configuration shown in Fig. 7 the gate contact 62 may surround the source contacts 60.

Fig. 8 illustrates a top view of a gate contact 62, a source contact 60, and a drain contact 64. The contacts are interdigitated with fingers of each contact being intertwined with fingers of the other contacts. Fig. 8 may be seen as illustrating a top view of any one of the transistors 1 shown in Figs. 1-2.

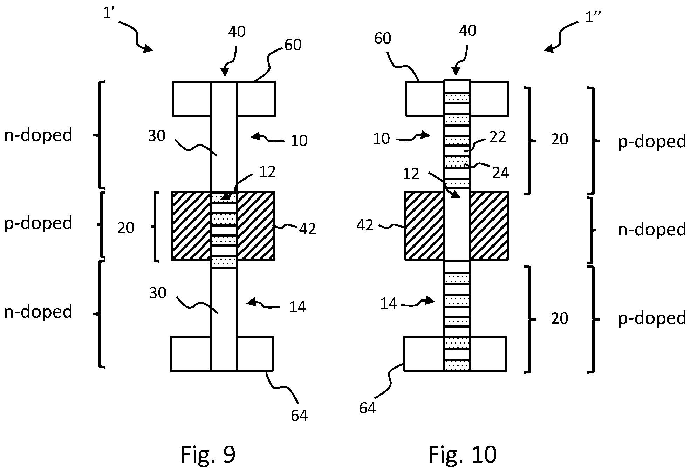

Fig. 9 and 10 respectively illustrate a cross sectional view of a transistor 1 wherein a single nanowire 40 confines the body 12 of the transistor 1. Thus, in the figures the body 12 is part of a single nanowire 40. Such transistors 1 may be called single nanowire transistors. Further, in the figures the nanowire 40 that confines the body 12 of the transistor 1 also confines the source 10 and the drain 14 of the transistor 1. Thus, in the figures source 10, body 12, and drain 14 are part of a single nanowire 40.

Fig. 9 illustrates a single nanowire NMOS transistor 1', wherein the p-doped body 12 comprises the plurality of semiconductor layers 20, of varying Al content, and wherein the n-doped source 10 and drain 14 do not comprise the plurality of semiconductor layers 20. The source 10 and drain 14 may comprise one single material, in this case n-doped GaN layer 30 respectively. As an alternative, the plurality of semiconductor layers 20 of the single nanowire NMOS transistor 1' may of course extend into the source 10 and/or drain 14.

Fig. 10 illustrates a single nanowire PMOS transistor 1", wherein both the p-doped source 10 and drain 14 comprise a plurality of semiconductor layers 20, of varying Al content, and wherein the n-doped body 12 do not comprise the plurality of semiconductor layers 20. In the illustration the n-doped body 12 comprise a single layer, e.g. a GaN layer. Alternatively, the p-doped body 12 may comprise plurality of semiconductor layers 20.

Figs. 9 and 10 further illustrates a gate contact 62 that wraps around the nanowire 40 that confines the body 12 of the transistor 1. Thus, in both Fig. 9 and 10 the gate contact 62 is a wrap-around gate 42. The figures further show that the source contact 60 and the drain contact 64 wraps around the nanowire 40.

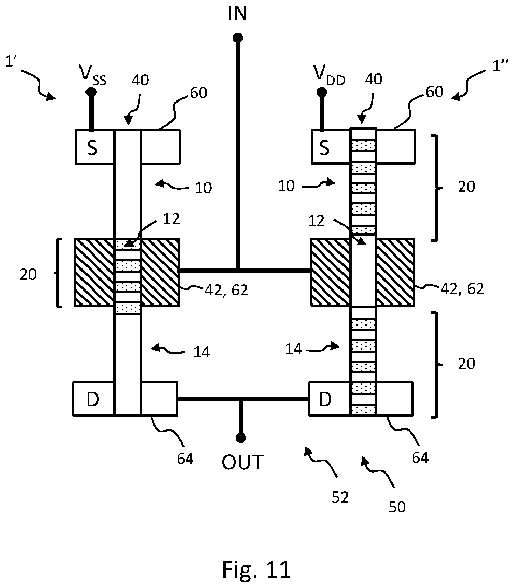

Fig. 11 illustrates a cross sectional view of an electrical device 50 comprising a CMOS circuit 52. The CMOS circuit 52 comprises a NMOS transistor 1' and a PMOS transistor 1". The NMOS transistor 1' comprises a plurality of semiconductor layers 20 in the p-doped body and the PMOS transistor 1" comprises a plurality of semiconductor layers 20 in the p-doped source 10 and a plurality of semiconductor layers 20 in the p-doped drain 14. The illustrated CMOS circuit 52 is an inverter. An inverter, such as the illustrated inverter, may comprise a NMOS transistor 1' and a PMOS transistor 1". Further, an input may be connected to the gate contact 62 of both the NMOS transistor 1' and the PMOS transistor 1". The source contact 60 of the NMOS transistor 1' may be connected to Vₛₛ and the source contact 60 of the PMOS transistor 1" may be connected to V_{DD}. The drain contacts 64 of the NMOS 1' and PMOS 1" transistors may be connected to each other and to an output. Thus, a signal on the input may be inverted on the output.

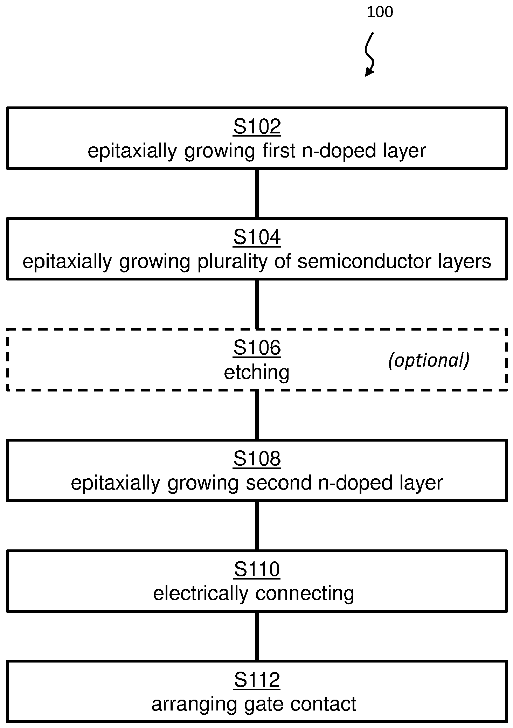

Fig. 12 illustrates a flow chart of a method 100 for producing a transistor 1. The method 100 is herein described as comprising the steps S102-S112. However, it should be understood that some of the steps are optional, as indicated in the figure. It should be understood that at least some of the steps may be performed in a different order than indicated in the figure, as readily understood by the skilled person. The method 100 may be e.g. be used to produce any one of the NMOS transistors 1' of Fig. 4, 5, or 9.

According to the method a first n-doped layer, a plurality of semiconductor layers 20, and a second n-doped layer are epitaxially grown, e.g. by MOVPE. The epitaxial growth may take place on a substrate, e.g. a Si, SiC, or sapphire substrate.

According to the method 100, a first n-doped layer of AIGaN or GaN is epitaxially grown S102. Dopants of n-type may be introduced in the gas phase of the MOVPE. Precursors such as e.g. trimethyl gallium (TMG), trimethyl aluminum (TMA), and NH₃ may be used for the growth.

A plurality of semiconductor layers 20 is epitaxially grown S104 on top of the first n-doped layer, wherein each layer of the plurality of semiconductor layers 20 is made of AIGaN or GaN, and wherein the plurality of semiconductor layers 20 is configured such that an aluminum content changes between each consecutive layer such that every second layer has a lower aluminum content than the neighboring mutually opposite layers thereof, wherein the plurality of semiconductor layers 20 is grown p-doped. Herein, dopants of p-type, e.g. Mg, may be introduced in the gas phase of the MOVPE. The aluminum content may be changed by changing precursor flows during the epitaxial growth, e.g. by changing a TMG/TMA ratio.

At this point the epitaxial growth may optionally be stopped. The substrate may be removed from the growth chamber. One or more nanowires 40 may then be etched S106 out from the plurality of semiconductor layers 20. The one or more nanowires 40 may be etched out perpendicular to the plurality of semiconductor layers 20, such that the axis of the nanowire 40 is perpendicular to the plurality of semiconductor layers 20. This may be done by lithographically patterning, e.g. by nanoimprint lithography, the top surface of the plurality of semiconductor layers 20 and then etching exposed areas. Etching may be done by wet etching, e.g. using hydrofluoric acid, or by dry etching, e.g. by reactive ion etching. The etched out nanowire 40 may confine part of the body 12 of the NMOS transistor 1'.

If the nanowires 40 are to be used free standing, the substrate may then be returned to the growth chamber and epitaxial growth may continue. In some cases, it may be advantageous to embed the nanowires 40, e.g. embed them in oxide or semi-insulating iron-doped gallium nitride, before continued epitaxial growth. Material grown during continued epitaxial growth may then be supported by the embedding material and spread laterally to connect several nanowires 40, e.g. connect several nanowires 40 to the same source 10, as illustrated in Figs. 4-6.

The method 100 further comprises epitaxially growing S108 a second n-doped layer of AIGaN or GaN, wherein the second n-doped layer is grown on top of the plurality of semiconductor layers 20. Said epitaxial growth S108 may thus be performed in the same growth session as the previous growth steps S102, S104, if no etching S106 is performed. Alternatively, if etching S106 is performed, said epitaxial growth S108 may be performed in another growth session.

The first n-doped layer, the plurality of semiconductor layers 20, and the second n-doped layer forms part of a semiconductor structure.

After the epitaxial growth S102, S104, S108, one of the first and second n-doped layers is electrically connected S110 to a source contact 60 and the other of the first and second n-doped layers to a drain contact 64. For example, a back-side contact to the substrate may be used to electrically connect the first n-doped layer. Alternatively, a trench may be etched down to the first n-doped layer and an electrical contact, such as the source 60 or drain 64 contact may be placed in the trench. The second n-doped layer may be electrically connected from the top. Electrically connecting an n-doped layer may comprise evaporating or sputtering one or more suitable metals to said n-doped layer. Further, said metals may be annealed to diffuse said metals into said n-doped layer. Thus, a high quality ohmic contact may be produced. Said metals may be e.g. Ag, Au, Ti, Ni, Al, or combinations thereof. For example, Ni/Au or Ti/Al/NiV may be used.

A gate contact 62 is arranged S112 on the semiconductor structure, the gate contact 62 being configured to apply an electric field to the plurality of semiconductor layers 20, such that an electrical conduction between the source 10 and the drain 14, via the plurality of semiconductor layers 20, is controllable by the gate contact 62. Arranging a gate contact 62 on the semiconductor structure may comprise depositing an electrical insulator, e.g. an oxide, on the semiconductor structure and then depositing a metal on said insulator.

The gate contact 62 may be arranged on the plurality of semiconductor layers 20. For example, on lateral surfaces of a nanowire 40 confining the plurality of semiconductor layers 20 (e.g. to form a wrap-around gate). Alternatively, the gate contact 62 may be arranged in the vicinity of the plurality of semiconductor layers 20, such that an electric field applied from the gate is strong enough to control the electrical conduction in the plurality of semiconductor layers. For example, the gate contact 62 may be arranged on the second n-doped layer or on a top surface of the semiconductor structure, in the vicinity of the plurality of semiconductor layers 20. The gate contact 62 may further be arranged in the vicinity of a source contact 60 or a drain contact 64.

The above described transistors may be implemented in many different ways, as readily understood by the skilled person. As further guidance it can be noted that:
When p-doping is mentioned it should be understood that it may refer to doping by Mg from e.g. the precursor Bis(cyclopentadienyl)magnesium,

Cp2Mg. A doping enhancement may be seen when a plurality of semiconductor layers 20 is p-doped by Mg. However, the same enhancement mechanism may also apply to other p-dopants.

When n-doping is mentioned it should be understood that it may refer to doping by Si from e.g. the precursor SiH₄. However, GaN-based materials may, at least under some circumstances, be intrinsically n-type. Thus, a n-doped region may not necessarily be actively doped.

Source contacts 60 and drain contacts 64 to n-doped regions may comprise one or more metals. One example of such a contact is Ti/Al/NiV. Another example of such a contact is a multilayer with a contact layer of Ti or Ta, an overlayer with Al or aluminum-copper alloy with a copper weight percent of less than 5%, a barrier layer of Ni, Ti, Pt, Pd, Mo, and a cap layer of Au.

Source contacts 60 and drain contacts 64 to p-doped regions may comprise one or more metals, such as Ni/Au bilayers or Ni/Ti/Au.

Gate contacts 62 to n-GaN may comprise e.g. Ti/Al/NiV and gate contacts to p-GaN may comprise Ni/Au bilayers or Ni/Ti/Au. However, it should be understood that another electrically conductive material may be used, e.g. doped polysilicon. An electrical insulator, e.g. an oxide, may separate the semiconductor structure from the metal (or other electrically conductive material) of the gate contact. The electrical insulator may be e.g. Al₂O₃, HfO₂, or Y₂O₃.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A transistor (1) comprising a source (10), a body (12) and a drain (14), the transistor (1) further comprising
a plurality of semiconductor layers (20), wherein layers of the plurality of semiconductor layers (20) are made of AIGaN or GaN, and wherein the plurality of semiconductor layers (20) is configured such that an aluminum content changes between each consecutive layer such that every second layer has a lower aluminum content than the neighboring mutually opposite layers thereof, wherein the transistor (1) is either
a N-channel metal-oxide-semiconductor, NMOS, transistor (1'), wherein part of the plurality of semiconductor layers (20) is p-doped and forms part of the body (12) of the NMOS transistor (1'); or
a P-channel metal-oxide-semiconductor, PMOS, transistor (1"), wherein part of the plurality of semiconductor layers (20) is p-doped and forms part of the source (10) or the drain (14) of the PMOS transistor (1").

2. The transistor (1) according to claim 1, wherein the plurality of semiconductor layers (20) comprises a repetition of a pair of semiconductor layers, wherein each pair of semiconductor layers comprises
a low Al content layer (22), having an Al content below 10%; and
a high Al content layer (24), having an Al content above 15%.

3. The transistor (1) according to claim 1 or 2, wherein each layer, of the plurality of semiconductor layers (20), has a thickness between 3 nm and 10 nm.

4. The transistor (1) according to any one of claims 1-3, wherein the transistor (1) is configured to pass a current mainly in a direction parallel to the layers of the plurality of semiconductor layers (20).

5. The transistor (1) according to any one of claims 1-3, wherein the transistor (1) is configured to pass a current mainly in a direction orthogonal to the layers of the plurality of semiconductor layers (20).

6. The transistor (1) according to claim 5, wherein a nanowire (40) confines at least part of the body (12) of the transistor (1).

7. The transistor (1) according to claim 6, wherein a gate contact (62) wraps around the nanowire (40) that confines at least part of the body (12) of the transistor (1), whereby the gate contact (62) forms a wrap-around gate (42).

8. The transistor (1) according to claim 6 or 7, wherein the nanowire (40) that confines at least part of the body (12) of the transistor (1) also confines at least part of the source (10) and the drain (14) of the transistor (1).

9. The transistor (1) according to any one of the preceding claims, wherein source (10), drain (14), and body (12) of the transistor (1) all comprise the plurality of semiconductor layers (20).

10. The transistor (1) according to any one of the preceding claims, wherein the transistor (1) is a NMOS transistor (1'), wherein
a source (10) of the NMOS transistor (1') comprises a n-doped GaN layer (30); and
a drain (14) of the NMOS transistor (1') comprises a n-doped GaN layer (30).

11. An electrical device (50) comprising:
at least one N-channel metal-oxide-semiconductor, NMOS, transistor (1'), the at least one NMOS transistor (1') comprising a plurality of semiconductor layers (20), wherein each layer of the plurality of semiconductor layers (20) of the NMOS transistor (1') is made of AIGaN or GaN, and wherein the plurality of semiconductor layers (20) of the NMOS transistor (1') is configured such that an aluminum content changes between each consecutive layer such that every second layer has a lower aluminum content than the neighboring mutually opposite layers thereof, wherein the plurality of semiconductor layers (20) of the NMOS transistor (1') forms part of a p-doped body (12) of the NMOS transistor (1'); and
at least one a P-channel metal-oxide-semiconductor, PMOS, transistor (1"), the at least one PMOS transistor (1") comprising a plurality of semiconductor layers (20), wherein each layer of the plurality of semiconductor layers (20) of the PMOS transistor (1") is made of AIGaN or GaN, and wherein the plurality of semiconductor layers (20) of the PMOS transistor (1") is configured such that an aluminum content changes between each consecutive layer such that every second layer has a lower aluminum content than the neighboring mutually opposite layers thereof, wherein the plurality of semiconductor layers (20) of the PMOS transistor (1") forms part of a p-doped source (10) or drain (14) of the PMOS transistor (1"),
wherein the at least one NMOS transistor (1') and the at least one PMOS transistor (1") of the electrical device (50) are connected to form a complementary metal-oxide-semiconductor, CMOS, circuit (52).

12. The electrical device (50) according to claim 11, wherein the at least one NMOS transistor (1') and the at least one PMOS transistor (1") of the CMOS circuit (52) share the same plurality of semiconductor layers (20).

13. The electrical device (50) according to claim 11 or 12, wherein at least one of the at least one PMOS transistor (1") and/or at least one of the at least one NMOS transistor (1') of the CMOS circuit (52) of the electrical device (50) is a transistor according to any one of claims 2-10.

14. A method (100) for producing a transistor, said method (100) comprising;
epitaxially growing (S102) a first n-doped layer of AIGaN or GaN;
epitaxially growing (S104) a plurality of semiconductor layers (20), wherein the plurality of semiconductor layers (20) is grown on top of the first n-doped layer, wherein each layer of the plurality of semiconductor layers (20) is made of AIGaN or GaN, and wherein the plurality of semiconductor layers (20) is configured such that an aluminum content changes between each consecutive layer such that every second layer has a lower aluminum content than the neighboring mutually opposite layers thereof, wherein the plurality of semiconductor layers (20) is grown p-doped;
epitaxially growing (S108) a second n-doped layer of AIGaN or GaN, wherein the second n-doped layer is grown on top of the plurality of semiconductor layers (20); whereby the first n-doped layer, the plurality of semiconductor layers (20), and the second n-doped layer form part of a semiconductor structure, the method (100) further comprising:
electrically connecting (S110) one of the first and second n-doped layers to a source contact (60) and the other of the first and second n-doped layers to a drain contact (64), whereby a transistor source (10) and a transistor drain (14) are formed by the first and second n-doped layers;
arranging (S112) a gate contact (62) on the semiconductor structure, the gate contact (62) being configured to apply an electric field to the plurality of semiconductor layers (20), such that an electrical conduction between the source (10) and the drain (14), via the plurality of semiconductor layers (20), is controllable by the gate contact (62), whereby a transistor body (12) is formed by the plurality of semiconductor layers (20).

15. The method (100) according to claim 14, further comprising
etching (S106) out a nanowire (40) from the plurality of semiconductor layers (20).
